Europäisches Patentamt

(19) **European Patent Office**

**Office européen des brevets**

(11) Publication number: **0 203 225**
A2

(12) # EUROPEAN PATENT APPLICATION

(21) Application number: **85116433.5**

(22) Date of filing: **21.12.85**

(51) Int. Cl.⁴: **H 01 L 29/64,** H 01 L 29/52, H 01 L 23/48, H 01 L 21/28, H 01 L 29/80

(30) Priority: **28.01.85 IT 1926285**

(43) Date of publication of application: **03.12.86**
**Bulletin 86/49**

(84) Designated Contracting States: **AT BE CH DE FR GB LI NL SE**

(71) Applicant: **TELETTRA Telefonia Elettronica e Radio S.p.A., Corso Buenos Aires 77/A, Milano (IT)**

(72) Inventor: **Donzelli, Giampiero, Via Don Gnocchi No. 28, IT-Milan (IT)**

(74) Representative: **Incollingo, Italo, Telettra S.p.A Patent Department Via Trento no. 30, I-20059 Vimercate (Milano) (IT)**

(54) **MESFET transistor with air layer between the connections of the gate electrode and the substrate and the respective fabrication process.**

(57) In the new structure of the Schottky barrier field effect MESFET transistor, consisting of a substrate and three electrodes (source, gate and drain), the electrical resistance of the gate is practically zeroed by using an electrode having the shape of a continuous sheet which bypasses a portion of source and created an air layer between its connections. The fabrication process basically includes a first photomasking, evaporation of the metallization layer on photoresist material, growing, a second photomasking and etching of total metallization and removal of the two photoresists.

## DESCRIPTION

supporting an application for an industrial invention patent titled: "MESFET TRANSISTOR WITH AIR LAYER BETWEEN THE CONNECTIONS OF THE GATE ELECTRODE AND THE SUBSTRATE AND THE RESPECTIVE FABRICATION PROCESS", in name of Telettra Telefonia Elettronica e Radio S.p.A., having its head office in Milan, corso Buenos Aires 77/A.

Designated inventor: Giampiero Donzelli.

ABSTRACT

In the new structure of the Schottky barrier field effect MESFET transistor, consisting of a substrate and three electrodes (source, gate and drain), the electrical resistance of the gate is practically zeroed by using an electrode having the shape of a continuous sheet which bypasses a portion of source and creates an air layer between its connections. The fabrication process basically includes a first photomasking, evaporation of the metallization layer on photoresist material, growing, a second photomasking and etching of total metallization and removal of the two photoresists.

The object of the present invention is a new type of structure for Schottky barrier field effect transistor (MESFET = Metal Semiconductor Field Effect Transistor) for application in the microwave field; the invention
also concerns a technological fabrication process.

As it is known, a MESFET includes a substrate, a
"source" electrode S (generally grounded), a "gate"
electrode G which the radio frequency signal RF is
applied to and a "drain" electrode D wherefrom the
amplified output signal is taken.

In the MESFET structures used in the microwave field,
a special role is played by the gate electrode metallization resistance. Minimizing the said parameter is
specially important in both low noise figure structures
and power structures for applications at very high
frequencies (microwave) in which the dimensions of the
gate electrodes G are below one micron. On the other
hand, just because of the said dimensions restrictions
exist in reducing gate metallization resistance.

The arrangements known and adopted so far can be basically classified as follows:

a) increasing thickness of metallization in electrodes

b) decreasing the length of the individual arms of the
   gate) which, as it will be better clarified  later
   on, is conventionally made up of two arms, vaguely
   looking like a diapason).

As far as item a) is concerned, there are technological
limitations which permit to increase thickness not more than 1 or 2 microns (therefore, a trade off must be
made).

As far as item b) is concerned, limitations are due
to the fact that drastically diminishing the length
of the individual gate arms results in increasing the
number of interconnections in the individual chips
(and consequently  the manufacturing yield is also
decreased) and in increasing the dimensions of the
chip (which is specially through in power FETs), which
in turn results in evident degradations in performances,
specially at high frequencies.

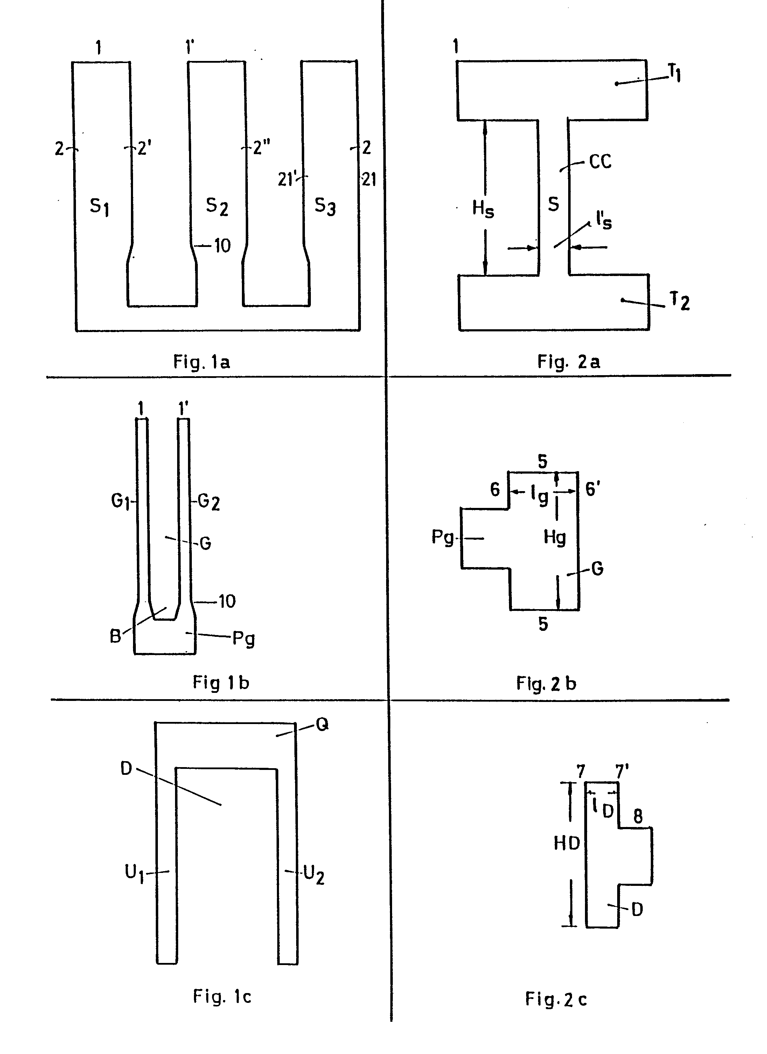

Just to have a  better idea of what said hereabove,
a conventional structure of modular-type MOSFET is
shown in figure 1: this structure is originally made
up of a source electrode S with three expansions S1,
S2, S3, at least one pair of gates G, G' each consisting of two arms G', G'1 (G2, G'2 respectively) and
one drain electrode D having the shape of an overturned U, i.e. formed of a base Q and two expansions U1
and U2.

A conventional  single   MESFET is obtained by cutting the structure in fig.1 in two sections along
line X-X. Figures 1a, 1b and 1c respectively show:
one source for two cells, one single gate and one
drain also for two cells. GaAs indicates the substrate by gallium arsenide.

As mentioned before, each gate arm (for instance G2, g"), is 150 to 200 micron long and the transversal "length"(width) shall be less than 1 micron in order to operate at the X-band frequencies , i.e. from 8 GHz approx up to 12 GHz approx. The major drawback is in that the radio frequency signal RF applied onto bump contact PG of a gate featuring narrow arms, and consequenctly high resistance, undergoes a degradation in its parameters or performances, increasing versus operating frequency.

Furthermore, to implement a power FET (for instance a 1 W power FET)more cells (each one of the type deriving from the cutting along X-X in fig. 1) must be connected in parallel between each other, which results in a greater technological complexity and an increase of the chip dimensions, as well as a reduction in the manufacturing yield; also, the number of connections and the risks for the RF signal to be fed to the individual cells with different phase shifts increase, as far as power level and consequently the number of cells to be used,increases.

The scope of the present invention is now such a MESFET structure which does not present the said drawbacks and, which is most important, results in a drastic reduc-

S

tion of gate.

Another scope of the invention is such a MESFET structure that, beside featuring a low gate resistance, also results in a reduction in the number of gate arms and consequently in the chip dimensions, and capable of providing praemium performances.

These purposes and other ones are achieved according to the present invention, thanks to the fact that the gate electrode is basically made up of a continuous sheet which bypasses through the air a relative portion of source electrode and is soldered to the substrate along a line, the area of the said sheet having such an extension as to present a substantially negligible resistance.

In a preferred form of implementation, electrode S is I-shaped, i.e. it presents two heads having a high transversal extension and a segment to connect the heads, having a lower transversal extension but a bigger axial extension, the gate is a sheet whose longitudinal extension is little less and transversal extension is by far greater than the corresponding extensions of the said segment and the axial extension of the drain electrode is little higher than the gate ones and the transversal width is of the same order of magnitude as that of the longitudinal source segment.

Preferably, the major side of the drain is parallel and
facing and slightly separated from the gate soldering
line, and the bump contact of the gate and drain are
centered onto the respective bodies, they have substantially equal areas and are on opposite sides with respect to the longitudinal source segment. This invention
also includes a process to implement the said structures
characterized by the fact that:

- the active zone is derived from the substrate and
  the source and drain contacts are implemented on the
  said active zone,

- a photomasking is made to define the gate electrode
  and the respective connection bump contact;

- a major portion of the metallization (Ti-Pd-Au) between the source and drain electrodes is made evaporate; the electrolytic growing, for instance of
  gold, is made up to the desired thickness (for instance 2 to 10 micron);

- a second photomasking is made to define the bridge
  or in-air bypass of the gate to the central source
  segment;

- finally, the etching of the total metallization
  (gold removal) is made in the area above the drain
  electrode, so as to leave the G soldering line in
  the  free area between D and S and the photoresist

- 6 -

materials are simultaneously removed, so as to implement the in-air bypass gate connection to the source.

These aspects and advantages of the invention and other ones will result more evident in the following description of the preferred, but not restrictive, forms of implementation shown in the drawings, in which:

- fig. 2 is a schematic top view(similar to fig.1) of a MESFET according to the invention;

- figures 2a, 2b and 2c are also schematic top views (similar to figures 1.a through 1.c) of the individual components of the MESFET in fig. 2;

- fig. 3 is a schematic cross-section view along line Y-Y in fig.2;

- and figures 4 through 7 are schematic cross-section views showing the phases of the process used to obtain the air connection of the gate with source by- pass in fig.3.

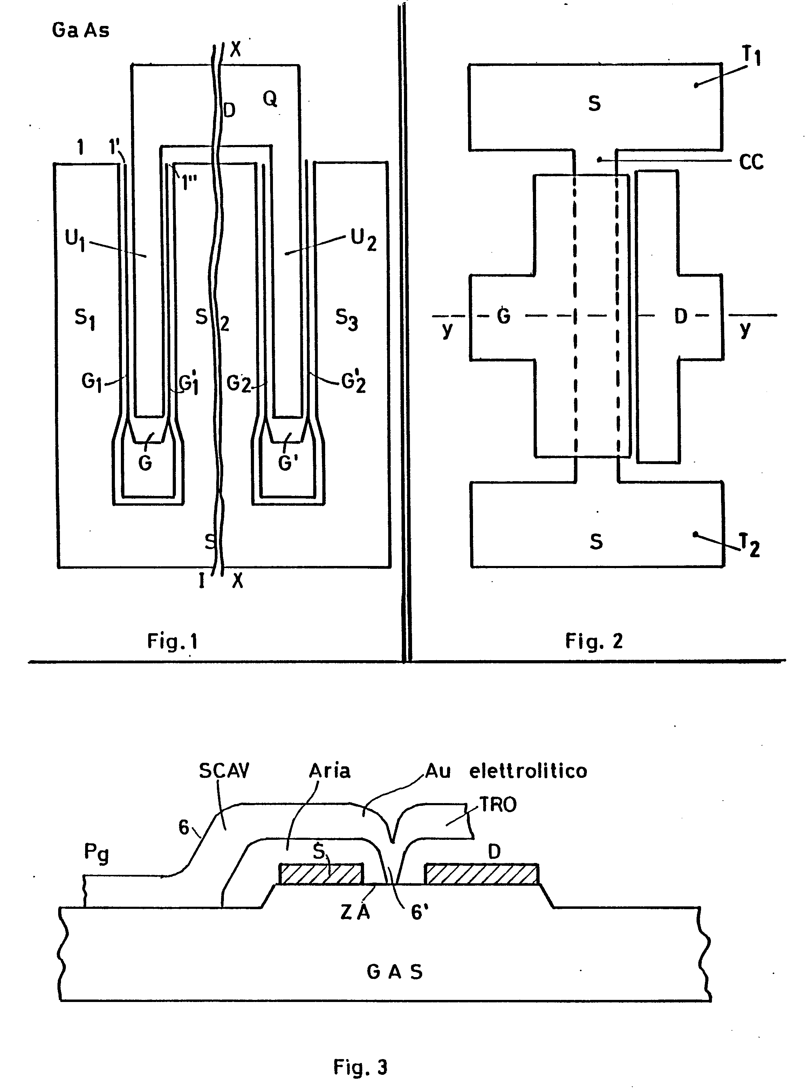

Fig. 2 is an overall view of the MESFET according to this invention, in which the three electrodes are still marked by symbols G, S and D respectively.

As figures 2a through 2c better show it, the source electrode S is now typically a body, I-shaped, consisting of two heads T1 and T2 and a connection segment CC; the heads are more extended along the transversal direction, i.e. their width $l_T$ is substantially greater than height $H_T$. On the other hand, the central connection segment CC between the heads is substantially longer than larger, i.e. $H_S > l'_S$. In fig. 2.a electrode S has been shown as made up of two equal heads and a segment having a constant width $l'_S$. It is clear that

$T_1$ may be different than T2 and S may vary along $H_S$.

According to a substantial aspect of the invention, the gate electrode (fig. 2b) is now a sheet having a

width $l_g$ substantially greater than $l'_S$ and a height

$H_g$ little less than $H_S$. Bump contact $P_g$ is only located at one side (6) and central. In this case too G has the extreme sides equal two by two, i.e. 5=5' and 6=6', however this equality is not imperative. Electrode D also substantially differs from the conventional one in fig. 1c and consists of a rectangular body whose

width $l_D$ is substantially equal to $l'_S$, but lower than

$l_G$, and a height $H_D$ substantially equal to $H_G$.

The geometrical differences of the individual electrodes of the MESFET according to the invention in figs. 2-2c are substantial, and the overall structure shown in fig. 2 is completely different than the structure of the conventional MESFET shown in fig.1.

Figure 3 shows a section along y-y in fig. 2 and it shows that the gate sheet according to the invention is fixed onto the GaAs substrate with its bump contact

$P_G$ on one side, and therefrom is bridged to S, via a
bypass SCAV, and is soldered to the active area ZA of
the GaAs substrate between S and D, with its side 6'.
Along the soldering line   6'  of G to GaAs there is
a metallization tail or section TRO which is used to
be sure about alignment and, as it will be better
seen later on, in order not to render the photoresist
attacking and removal operations critical.

The new structure of MESFET according to the invention
(figures 2-2c and 3) offers, amongst others, the following advantages:

1) Drastic reduction of gate electrical resistance,
   because of the gate electrode G being practically
   implemented by a metallization sheet instead of a
   very thin line (compare figures 1b and 2b).

2) The axial length $(H_G)$ is lower, and also the number
   of gate electrode arms is significantly reduced,
   and consequently the dimensions of the chip are
   substantially reduced (reduction factor 1:4 passing from fig.1 to fig.2).

3) Using 1 micron electrodes makes it possible to
   achieve performances similar to those provided by
   devices having sub-micrometric dimensions, and consequently results in evident advantages in the man-
   ufactoring yields.

4) The connection of the gate electrode through an air
bridge according to the invention (fig.3) results
in a negligible increase of the spurious capacitances of the chip.

The peculiarity of the said structure is in that,
whilst in a conventional structure the gate bump contact is connected to a long and thin electrode
($H'_G$ = 100 to 200 micron; $l'_g \leq 1$ micron), in this
case the connection is made all along width $H_G$ (almost
zero metallization resistance).

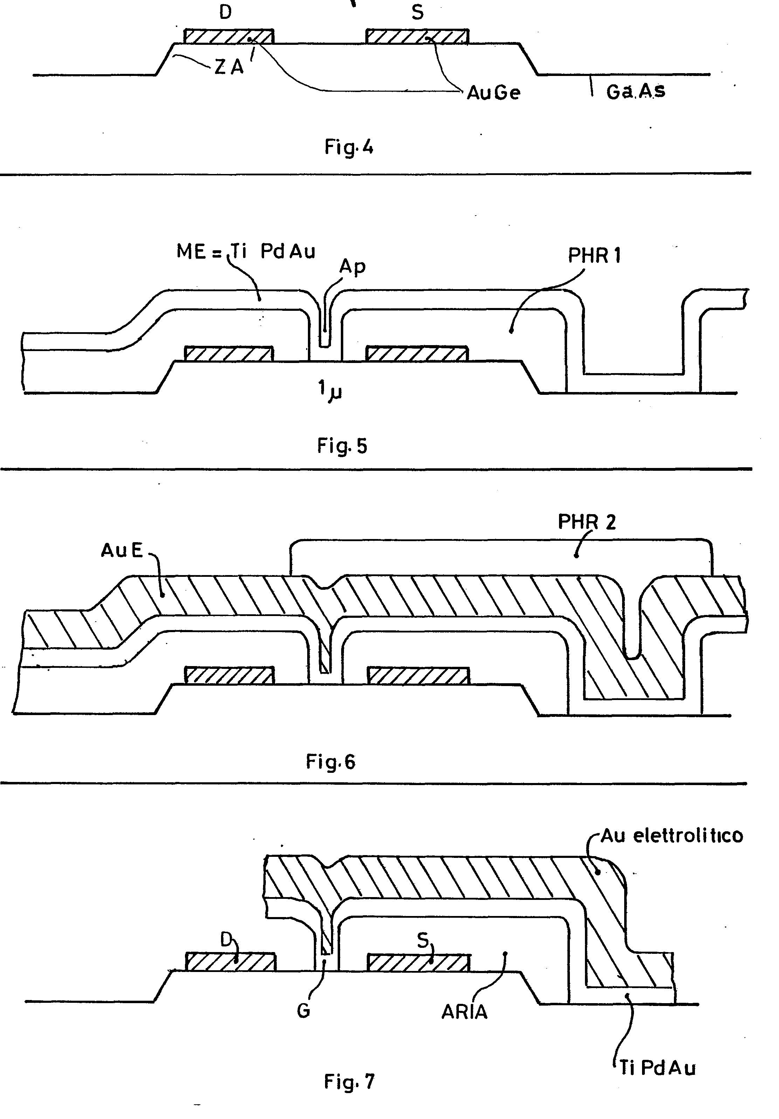

The operating steps of a technological process (preferred but not restricted) for the manufacturing of
the structure according to the invention are schematically shown in figures 4 and 7.

The said operating steps include:

1) (Fig.4) Implementation of the active area ZA onto
the GaAs substrate and implementation of the
"source" S and "Drain" D contacts for instance
using Au Ge (possibly, also Ni);

2) (Fig.5) First photomasking for the definition of
the gate electrode G and the connection bump contact $P_G$, evaporation onto the first photoresist
$PHR_1$ of the metallization layer ME (for instance
Ti-Pd-Au).

3) (Fig.6) Electrolytical growing of gold AUE up to

11

the desired thickness (S=10 micron approx) - second photomasking with a second photoresist PHR2 for the definition of the bridge connection.

4) (Fig.7) Etching of the total metallization ME + AUE (removal of Au and photoresist) - implementation of the structure with air connection.

It is evident that both this process and the MESFET structure (fig.2) are susceptible of modifications by those skilled in the art and consequently may be considered as comprised in the widest scope or spirit of the present invention.

12

CLAIMS

1) A Schottky barrier metal-semiconductor field effect
   transistor (MESFET) including a substrate, a gate
   electrode, which the input signal is fed to, a
   drain electrode to take the amplified output signal and a source electrode, characterized by the
   fact that the gate electrode (G) is made up of
   one body having the shape of a continuous sheet
   which by-passes through the air a portion of the
   source electrode and is soldered to the substrate
   at a side of the said portion with a bump contact
   and, at the other side of the source portion, along
   a line corresponding to all the longitudinal extension of the sheet, which has such an area that the resistance of the gate electrode is negligible

2) A transistor according to claim 1, characterized by
   the fact that the source electrode has an I shape,
   i.e. it includes two heads having a big transversal
   extension and a connection segment between the
   said heads having a small transversal extension
   but a great axial extension and the gate sheet has
   a longitudinal extension little less and a transversal extension much higher than those of the
   said source segment by-passed thereby.

3) A transistor according to claim 1, characterized
   by the fact that the drain electrode has an axial
   extension little higher than that of the gate sheet
   and a transversal width of the same order of magnitude as the source segment by-passed through the
   air by the gate sheet.

4) A transistor according to the previous claims, characterized by the fact that the major side of the
   drain is parallel, facing and slightly separated
   from the soldering line of the gate by-pass end
   to the substrate.

5) A transistor according to the previous claims, characterized by the fact that the gate and drain bump
   contacts are centered onto the respective bodies,
   have areas of the same order of magnitude and are located at opposite sides with respect to the longitudinal source segment.

6) A transistor according to the previous claims, characterized by the fact that the gate and drain with
their external central bump contacts are substantially specular with respect to the connection segment
between the source heads.

7) A process for the fabrication of MESFET transistors
according to the previous claims, characterized by
the fact that:

- the active area is derived from the substrate and
the source and drain contacts are implemented
thereon;

- a photomasking process is made to define the
. gate electrode and the respective connection bump
contact;

- a major portion of the metallization (Ti-Pd-Au)
between the source and the drain is made evaporate
and an electrolytic growing is made, for instance
using gold, up to the desired thickness (for instance 2 to 10 micron);

- a second photomasking process is made to define
the bridge connection or air by-pass of the gate
onto the central source segment;

- finally,the total metallization is etched (gold removal) in that area located above the drain electrode, so as to leave the soldering line of G in the free zone between D and $S_G$ and simultaneously the photoresist materials are removed, so as to implement the air by-pass gate connection to the source.

Fig. 1a

Fig. 2a

Fig 1b

Fig. 2b

Fig. 1c

Fig. 2c

Ga As

Fig. 1

Fig. 2

Fig. 3

D    S

ZA    AuGe    Ga.As

Fig. 4

ME = Ti Pd Au    Ap    PHR 1

1μ

Fig. 5

Au E    PHR 2

Fig. 6

Au elettrolitico

D    S

G    ARIA    Ti Pd Au

Fig. 7